# EUROPEAN PATENT SPECIFICATION

(11) **EP 4 475 417 B1**
(45) Date of publication and mention of the grant of the patent: **06.05.2026**
(21) Application number: 23755833.3
(22) Date of filing: 16.02.2023
(51) Int. Cl.: H02M 3/155, H03K 17/795, H03K 17/785, G05F 1/56

(54) **POWER SUPPLY CIRCUIT**
STROMVERSORGUNGSSCHALTUNG
CIRCUIT D'ALIMENTATION ÉLECTRIQUE

(30) Priority: 17.02.2022 CN 202210147507; 09.04.2022 WO PCT/CN2022/085989; 20.11.2022 CN 202211451338; 02.12.2022 CN 202211539292; 15.02.2023 WO PCT/CN2023/076046
(43) Date of publication of application: 11.12.2024
(73) Proprietor: SEMITRI PTY LTD, Wheelers Hill, VIC 3150 (AU)
(72) Inventor: Guo, Qiaoshi, Guangzhou, Guangdong 511447 (CN)
(74) Representative: Sun, Yiming
(86) International application number: PCT/CN2023/076467
(87) International publication number: WO 2023/155832

(56) References cited:
- CN-A- 103 458 341
- CN-A- 106 160 417
- CN-Y- 201 207 742
- JP-A- 2013 038 850
- US-A- 4 450 517
- US-A- 4 652 764
- US-A- 4 945 301

## Description

### TECHNICAL FIELD

The present invention relates generally to a power supply circuit, and more specifically, to a power supply circuit that can output pure current (voltage) for power supply of an audio circuit.

### BACKGROUND

The current (voltage) outputted by power supply circuits of conventional electronic circuits can be readily affected by the influence of the voltage of input power sources (e.g., ripple, ultra-low-frequency voltage fluctuations, harmonics, and electromagnetic interference), and there also exist problems that electric grid interference can be easily introduced and the normal operation of a circuit can be affected by impure output current (voltage).

US 4 652 764 A and US 4 450 517 A disclose prior art power supply circuits.

### SUMMARY

The objects of the present invention is to solve the problems mentioned in Background and to provide a power supply circuit that can output pure current (voltage).

An apparatus according to the invention is defined in the appended independent claim. Preferred embodiments are defined in the dependent claims.

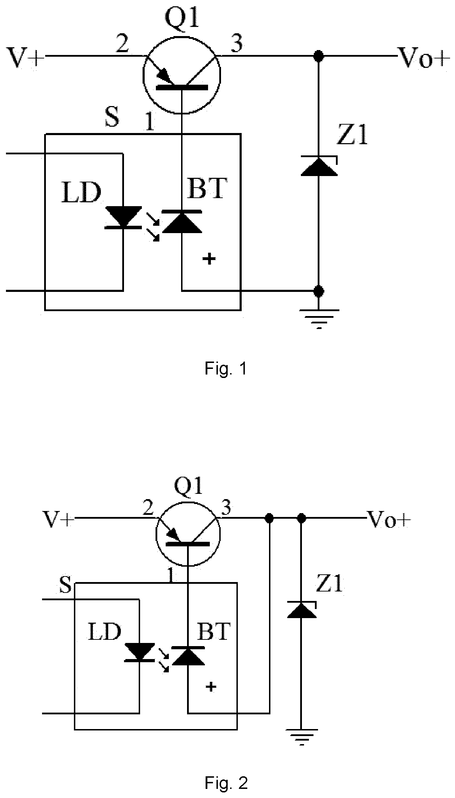

As shown in FIG. 1, a power supply circuit comprises a device Q1, a light-emitting element LD, and a receiving element BT (which may be a photodiode or photocell). A second electrode 2 and a third electrode 3 of the device Q1 are used to form a first series circuit with a load (i.e. the load connected to Output Terminal VO+; the load is an amplification circuit) requiring for power supply. The light-emitting element LD provides the receiving element BT, which is connected to a first electrode of the device Q1, with optical signals. The electrical signals produced by the receiving element BT are amplified by the device Q1 operating in its amplification region and provided to the load. Since the output current of the device Q1 is dependent on the counterpart of the receiving element BT, so that the purity (stability) of the output current can be realized.

The present invention is reasonable in design, having the advantage of high purity (namely, hardly to be affected by the influence of the power quality of input power sources and electromagnetic interference) of output current (voltage).

### BRIEF DESCRIPTION OF THE DRAWINGS

FIG. 1 is a schematic diagram of a power supply circuit as well as a schematic diagram 1 of Embodiment 1 of the present invention.
FIG. 2 is schematic diagram 2 of Embodiment 1 of a power supply circuit of the present invention.
FIG. 3 is schematic diagram of Comparative Example 1 of a power supply circuit useful to understand the present invention.
FIG. 4 is schematic diagram 1 of Comparative Example 2 of a power supply circuit useful to understand the present invention.
FIG. 5 is schematic diagram 2 of Comparative Example 2 of a power supply circuit of the present invention.

### DETAILED DESCRIPTION

Embodiments and comparative examples of a power supply circuit are shown in FIG. 1, FIG. 2, FIG. 3, FIG. 4 and FIG. 5. A power supply circuit comprises a device Q1, a light-emitting element LD, and a receiving element BT. A second electrode 2 and a third electrode 3 of the device Q1 are used to form a first series circuit with a load (i.e. the load connected to Output Terminal VO+ or VO-; the load is an amplification circuit) requiring for power supply. The light-emitting element LD provides the receiving element BT, which is connected to a first electrode of the device Q1, with optical signals. The electrical signals produced by the receiving element BT is amplified by the device Q1 operating in its amplification region and provided to the load. Since the output current of the device Q1 is dependent on the counterpart of the receiving element BT, so that the purity (stability) of the output current can be realized.

### Embodiment 1 of the present invention:

FIG. 1 and FIG. 2. are schematic diagram 1 and schematic diagram 2 of the present embodiment, respectively. A second electrode 2, a first electrode 1, and a receiving element BT are connected in series to form a driver circuit for device Q1; the driver circuit is connected to an input power source in parallel (as shown in FIG.1). FIG.2 shows that the two ends of the receiving element BT are connected to the first electrode 1 and a third electrode 3, respectively. The main advantage in FIG.1 and FIG.2 is that operational requirements can be still readily satisfied even if the receiving element BT has extremely small output voltage, wherein the receiving element BT can adopt a single photodiode.

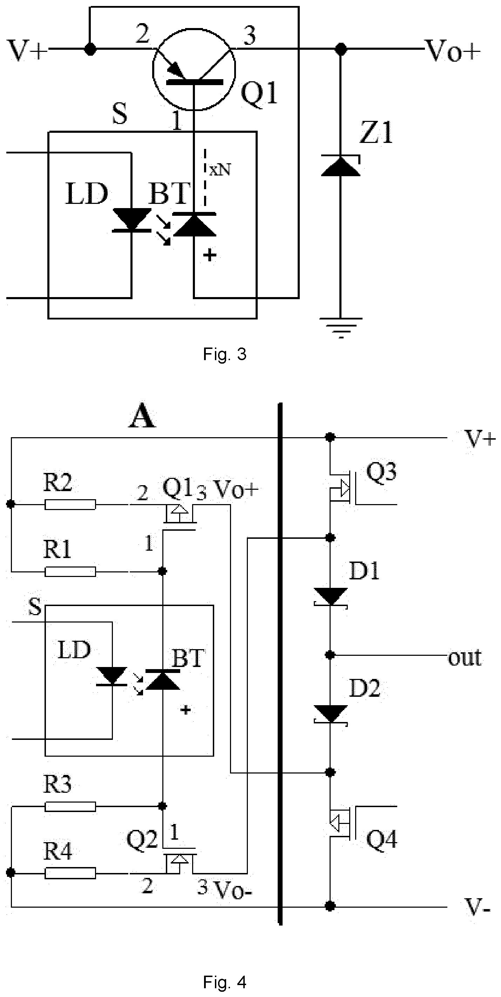

As shown in FIG.3, in Comparative Example 1 useful to understand the present invention, the two ends of the receiving element BT are connected to the first electrode 1 and the second electrode 2, respectively. The output voltage of the receiving element BT is required to be high enough to drive the device Q1 into amplification state (without entering into saturation state, however). The receiving element BT may adopt a plurality of photodiodes used in a way of serial connection, with the main advantage of overcoming the influence from the junction capacitor in the receiving element BT.

Comparative Example 2 useful to understand the present invention:

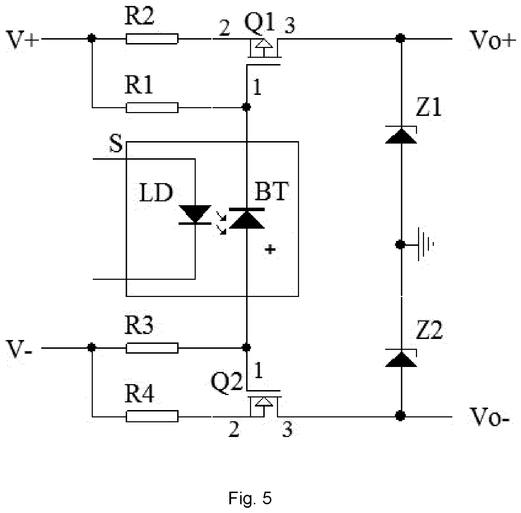

FIG.4 (the circuit of the present invention is in the part A, used for the power supply for class-A power amplifiers bias) and FIG.5 show that a power supply circuit includes a device Q1 (the first device), a device Q2 (the second device), a first element R1, a second element R2, a third element R3, and a fourth element R4. A first electrode of the device Q1 is connected to a first electrode of the device Q2 via a receiving element BT. The first and second devices Q1 and Q2 are used for constant current with positive and negative power sources, respectively. The two ends of the first element R1 are connected to the first and second electrodes of the first device Q1 (note that the first element R1 is connected to the second electrode of the device Q1 via the second element R2, wherein R2 is preferably adopted), respectively. The two ends of the third element R3 are connected to the first and second electrodes of the second device Q2 (note that the third element R3 is connected to the second electrode of the device Q2 via the fourth element R4, wherein R4 is preferably adopted), respectively. The first element R1 and the third element R3 are used for converting BT's current signals into voltage signals.

In this example, the first electrode of device Q1 is connected to the counterpart of the device Q2 via the receiving element BT which is not connected to ground. It can effectively overcome the influence of the junction capacitor in the receiving element BT and the asymmetry between the positive and negative output caused by the output current (voltage) drift of the receiving element BT, making it especially suitable for the implementations having loads such as op-amps powered by positive and negative power sources or amplification circuits with discrete components.

In the foregoing embodiments and examples, a voltage-stabilizing unit Z1 (Z2) may be further included for realizing constant voltage output. The voltage-stabilizing unit may be connected to a capacitor in parallel. The voltage stabilizing unit Z1(Z2), which is a zener diode-or a transistor circuit in practical implementation-is used to connected in parallel to the load connected to the terminal VO+ (VO-). When a transistor circuit is adopted, it can provide a feedback signal to control the driver circuit of the light-emitting element, so as to regulate the output current of the device by adjusting the driver current of the light-emitting element.

The foregoing embodiments may have a plurality of light-emitting elements connected in series or in parallel; may have a plurality of receiving elements connected in series or in parallel. The light-emitting element is preferably an LED. The values of the constant current of the device are regulated through adjusting the driver current of the light-emitting element. For ease of implementation, the light-emitting element LD and receiving element BT are packaged as a whole, to form a photocoupler S. The light-emitting element is suggested be driven with constant current or voltage.

In the foregoing embodiments and examples, the device Q1 (Q2) is preferably an FET (since the output current of FET is hardly influenced by the voltage changings between the second and third electrodes, and also considering the constant-current characteristics of the receiving element, it is realizable that the output current maintains stable even there are extremely large fluctuations or interference in the load and input power source). When device Q1 is adopted as an FET in the circuits shown in FIG.1-3, a resistor (the first element R1, for example) may be connected between the second and first electrodes of the device Q1, as referred to FIG.4-5 of Comparative Example 2. The first electrode is a gate; the second electrode is a source; the third electrode is a drain.

In the foregoing embodiments and examples, R1 and R3 may be adopted as a resistor (preferably), or a zener diode.

The current invention is especially suitable for powering electronic circuits with loads such as voltage amplification circuits (e.g. audio amplification circuits or op-amp integrated circuits) and Class-A power amplifier bias (e.g. audio amplification circuits or high-speed power amplification circuits), or the circuits operating under the environments of intense electromagnetic interference.

The present invention is reasonable in design, having the advantage of high purity (namely, hardly to be affected by the influence of the power quality of input power sources and electromagnetic interference) of output current (voltage).

## Claims

1. A power supply circuit comprising a device (Q1), of which a second electrode (2) and a third electrode (3) are configured to form a first series circuit with a load requiring for power supply, the power supply circuit having a positive power source (V+) and a power ground, wherein the positive power source is connected to the second electrode (2), wherein the power supply circuit further comprises a light-emitting element (LD) and a receiving element (BT), the receiving element is a photoelectric converting element, the light-emitting element (LD) is configured to provide the receiving element (BT) with optical signals,
the electrical signals produced by the receiving element (BT) are amplified by the device (Q1) and provided to the load, the device (Q1) is configured to operate in its amplification region,
wherein the power supply circuit further comprises a voltage-stabilizing unit (Z1) which is configured to be connected to the load in parallel, wherein one end of the voltage-stabilizing unit (Z1) is connected to the third electrode (3) and another end of the voltage-stabilizing unit (Z1) is connected to the power ground of the power supply circuit;
wherein the second electrode (2), the first electrode (1), and the receiving element (BT) are connected in series to form a driver circuit for the device (Q1);
wherein one end of the receiving element (BT) is connected to a first electrode (1) of the device (Q1), and another end of the receiving element (BT) is connected either to the power ground or to the third electrode (3).

2. The power supply circuit according to claim 1, wherein the device (Q1) is configured for constant current.

3. The power supply circuit according to claim 1, wherein the light-emitting element (LD) is an LED.

4. The power supply circuit according to claim 1, wherein the photoelectric converting element is a photodiode.

5. The power supply circuit according to claim 1, wherein the voltage-stabilizing unit (Z1, Z2) is a zener diode or a transistor circuit.

## Patentansprüche

1. Stromversorgungsschaltung, umfassend ein Bauelement (Q1), dessen zweite Elektrode (2) und dritte Elektrode (3) dazu ausgebildet sind, mit einer mit Strom zu versorgenden Last einen ersten Serienschaltkreis zu bilden, wobei die Stromversorgungsschaltung eine positive Spannungsquelle (V+) und eine Masse aufweist, wobei die positive Spannungsquelle mit der zweiten Elektrode (2) verbunden ist, wobei die Stromversorgungsschaltung ferner ein lichtemittierendes Element (LD) und ein Empfangselement (BT) umfasst, wobei das Empfangselement ein photoelektrisches Wandelelement ist, das lichtemittierende Element (LD) dazu ausgebildet ist, das Empfangselement (BT) mit optischen Signalen zu versorgen,
die von dem Empfangselement (BT) erzeugten elektrischen Signale durch das Bauelement (Q1) verstärkt und der Last zugeführt werden, wobei das Bauelement (Q1) dazu ausgebildet ist, in seinem Verstärkungsbereich zu arbeiten,
wobei die Stromversorgungsschaltung ferner eine Spannungsstabilisierungseinheit (Z1) umfasst, die dazu ausgebildet ist, parallel zu der Last verbunden zu werden, wobei ein Ende der Spannungsstabilisierungseinheit (Z1) mit der dritten Elektrode (3) verbunden ist und ein anderes Ende der Spannungsstabilisierungseinheit (Z1) mit der Masse der Stromversorgungsschaltung verbunden ist;
wobei die zweite Elektrode (2), die erste Elektrode (1) und das Empfangselement (BT) in Serie verbunden sind, um eine Treiberschaltung für das Bauelement (Q1) zu bilden;
wobei ein Ende des Empfangselements (BT) mit einer ersten Elektrode (1) des Bauelements (Q1) verbunden ist und ein anderes Ende des Empfangselements (BT) entweder mit der Masse oder mit der dritten Elektrode (3) verbunden ist.

2. Stromversorgungsschaltung nach Anspruch 1, wobei das Bauelement (Q1) für Konstantstrom ausgebildet ist.

3. Stromversorgungsschaltung nach Anspruch 1, wobei das lichtemittierende Element (LD) eine LED ist.

4. Stromversorgungsschaltung nach Anspruch 1, wobei das photoelektrische Wandelelement eine Photodiode ist.

5. Stromversorgungsschaltung nach Anspruch 1, wobei die Spannungsstabilisierungseinheit (Z1, Z2) eine Zenerdiode oder eine Transistorschaltung ist.

## Revendications

1. Circuit d'alimentation comprenant un dispositif (Q1), dont une deuxième électrode (2) et une troisième électrode (3) sont configurées pour former un premier circuit en série avec une charge nécessitant une alimentation électrique, le circuit d'alimentation ayant une source d'alimentation positive (V+) et une masse, dans lequel la source d'alimentation positive est connectée à la deuxième électrode (2), dans lequel le circuit d'alimentation comprend en outre un élément émetteur de lumière (LD) et un élément récepteur (BT), l'élément récepteur étant un élément de conversion photoélectrique, l'élément émetteur de lumière (LD) étant configuré pour fournir à l'élément récepteur (BT) des signaux optiques,
les signaux électriques produits par l'élément récepteur (BT) étant amplifiés par le dispositif (Q1) et fournis à la charge, le dispositif (Q1) étant configuré pour fonctionner dans sa région d'amplification,
dans lequel le circuit d'alimentation comprend en outre une unité de stabilisation de tension (Z1) qui est configurée pour être connectée en parallèle à la charge, dans lequel une extrémité de l'unité de stabilisation de tension (Z1) est connectée à la troisième électrode (3) et une autre extrémité de l'unité de stabilisation de tension (Z1) est connectée à la masse du circuit d'alimentation ;
dans lequel la deuxième électrode (2), la première électrode (1), et l'élément récepteur (BT) sont connectés en série pour former un circuit d'attaque du dispositif (Q1) ;
dans lequel une extrémité de l'élément récepteur (BT) est connectée à une première électrode (1) du dispositif (Q1), et une autre extrémité de l'élément récepteur (BT) est connectée soit à la masse, soit à la troisième électrode (3).

2. Circuit d'alimentation selon la revendication 1, dans lequel le dispositif (Q1) est configuré pour un courant constant.

3. Circuit d'alimentation selon la revendication 1, dans lequel l'élément émetteur de lumière (LD) est une LED.

4. Circuit d'alimentation selon la revendication 1, dans lequel l'élément de conversion photoélectrique est une photodiode.

5. Circuit d'alimentation selon la revendication 1, dans lequel l'unité de stabilisation de tension (Z1, Z2) est une diode Zener ou un circuit à transistor.
